# EUROPEAN PATENT SPECIFICATION

(11) **EP 2 841 620 B1**
(45) Date of publication and mention of the grant of the patent: **05.12.2018**
(21) Application number: 13782210.2
(22) Date of filing: 22.04.2013
(51) Int. Cl.: C23C 16/00, C23C 16/455, C03C 17/00, C23C 16/54, C23C 16/44

(54) **HOOD FOR METAL-OXIDE VAPOR COATING GLASS CONTAINERS**
HAUBE ZUR METALLOXIDDAMPFBESCHICHTUNG VON GLASBEHÄLTERN
HOTTE POUR LE REVÊTEMENT EN PHASE VAPEUR DE RÉCIPIENTS EN VERRE PAR UN OXYDE MÉTALLIQUE

(30) Priority: 27.04.2012 US 201261639164 P
(43) Date of publication of application: 04.03.2015
(73) Proprietor: Arkema, Inc., King of Prussia, PA 19406 (US)
(72) Inventor: FAHEY, Kaitlyn, Carlsbad, California 92008 (US)
(74) Representative: Albani, Dalila
(86) International application number: PCT/US2013/037520
(87) International publication number: WO 2013/163055

(56) References cited:
- WO-A1-96/20142
- US-A- 5 140 940
- US-A- 5 454 873
- US-A- 5 599 369
- US-A1- 2010 022 097
- US-A1- 2011 232 568

## Description

### FIELD OF THE INVENTION

This invention relates to a hood for coating glass containers with a metal-oxide vapor.

### BACKGROUND OF THE INVENTION

This invention is concerned with a hood for vapor coating glass containers to control the amount and placement of the metal-oxide coating on the container sidewalls and finish of the glass containers.

As described in U.S. Patent Nos. 5,599,369 and 5,140,940, which are both incorporated by reference herein in their entirety, the desirability of applying a metal-oxide coating to the exterior of a glass container has long been recognized. Such coatings, which include tin, titanium, or other reactive metallic compounds, or organometallic compounds, protect the glass container from surface damage, such as abrasions and scratches, which result in a loss of tensile strength for the glass container. The need for high tensile strength in a glass container is particularly acute when containers are mass produced, move rapidly in close proximity along high speed conveyor lines, and are subsequently filled with carbonated beverages, beer, wine, foodstuffs and the like that produce gaseous pressure within the container.

The metal-oxide coating is typically applied when the glass container emerges in a heated, fully shaped condition from a glassware forming machine, that is at the "hot end" of the system. The containers are transported away from the forming machine by a conveyor. Temperatures in excess of 400 degrees Centigrade exist at the surface of the glass containers, so that when a heat decomposable inorganic metallic, or organometallic, compound is applied thereto, the compound reacts immediately and is converted to a metal-oxide coating.

One well-known and previously widely used technique for applying a protective coating to the hot glass containers calls for spraying the opposite sides of the containers as they travel on a conveyor in single file through spray heads positioned for optimal coating of the glass surface of a particular container. Receivers are positioned on the opposite side of the conveyor in alignment with the respective spray heads. Pressurized air or inert gas with the coating compound entrained therein is discharged from one or a plurality of spray heads at a significant positive pressure, while the receivers are usually maintained at a relatively low pressure. The resultant pressure differential increases the velocity, and thus the effectiveness, of the coating-precursor compound. Coating system of this nature are disclosed, inter alia, in U.S. Pat. No. 3,516,811, to Gatchet, et al., and U.S. Pat. No. 3,684,469, to Goetzer, et al., each of which is incorporated by reference herein in their entirety.

The above-described coating systems, however, are what may be termed "open-sided," and may be adversely influenced by ambient conditions in the facility where the glass containers are formed.

A second, well-known, and widely employed technique for applying a protective coating to hot glass containers relies upon a formed sheet-metal coating hood with spray heads and associated receivers situated therein. The hood obviates many of the problems associated with the open-ended spray systems discussed above. For example, it isolates the glass containers from ambient conditions, and furnishes a controlled atmosphere which enhances the coating operations. The hood includes an exhaust system which captures most of the air-entrained coating compound not adhering to the containers, thus reducing the problem of venting the system and minimizing the opportunity for the coating compound to attack building components. Also, that hood can significantly raise the coating efficiency of the systems, with attendant cost savings.

Coating hoods substantially representative of the prior art are disclosed in U.S. Pat. No. 3,819,404 to Scholes et al.; U.S. Pat. No. 3,933,457, to Scholes; and U.S. Pat. No. 4,389,234 to Lindner, each of which is incorporated by reference herein in their entirety. U.S. Pat. No. 4,389,234 to Lindner describes a coating hood including a tunnel for allowing containers to pass therethrough, and a vertically adjustable flat roof for accommodating containers of various sizes. At least two jet slots are located in each side wall, and at least two receivers or suction slots are aligned therewith. The jet and suction slots are interspersed opposite each other in each sidewall. The coating compound is introduced through at least one feedpoint, and blowers secured to the sidewalls furnish an inner and an outer loop of high-velocity air, of which the inner loop contains the coating compound, to the interior of the hood. Baffles are situated in the flow path of the high-velocity air so that the jets issuing from the jet slots are well defined, and thus better suited for their intended function. U.S. Pat. No. 5,454,873 to Scholes describes an apparatus for applying a cold end coating on glassware, where organic acids with melting points are applied as coating compounds.

### SUMMARY OF THE INVENTION

According to one aspect of the invention, an apparatus for coating glass articles with a chemical compound according to claim 1 is provided. The apparatus includes a coating hood section defining an interior chamber; and an injector, which is configured to deliver the chemical compound into the interior chamber of the coating hood section, that extends into the interior chamber by a pre-determined distance that is selected to prevent premature vaporization of the chemical compound.

### BRIEF DESCRIPTION OF THE DRAWING FIGURES

The invention is best understood from the following detailed description when read in connection with the accompanying drawing. Included in the drawing are the following figures:
FIG. 1 depicts a side elevation view of a prior art coating hood for bottles or jars, the hood having a flat inner wall with vapor slots.
FIG. 2 depicts a cross-sectional plan view of the prior art coating hood of FIG. 1 taken along lines 2-2 of FIG. 1.
FIG. 3 depicts a plan view showing another prior art coating hood coating hood having an inner-wall configuration designed to reduce inner surface temperature.
FIG. 4 depicts a front elevation view of a coating hood, which is shown schematically, according to the instant disclosure.
FIG. 5 depicts a right-side elevation schematic view of the coating hood of FIG. 4.
FIG. 6 depicts a cross-sectional schematic view of the coating hood of FIG. 5 taken along the lines 6-6.
FIG. 7 depicts another cross-sectional schematic view of the coating hood of FIG. 5 (blower motors omitted), depicting the flow path of vapor through the coating hood.
FIG. 8 depicts a cross-sectional view of a segment of tubing mounted to the injector of FIG. 4.

### DETAILED DESCRIPTION OF THE DRAWING FIGURES

The invention is best understood from the following detailed description when read in connection with the accompanying drawing figures, which shows exemplary embodiments of the invention selected for illustrative purposes. The invention will be illustrated with reference to the figures. Such figures are intended to be illustrative rather than limiting and are included herewith to facilitate the explanation of the present invention.

This invention is applicable to the common case of coating bottles using monobutyltinchloride (MBTC); however, the apparatus described herein is applicable generally to the coating of glass with films of tin oxide, titanium oxide or other single metal oxide, or with a mixture of a plurality thereof, using organometallic compounds, metal halides or other suitable compounds as the coating-chemical precursor.

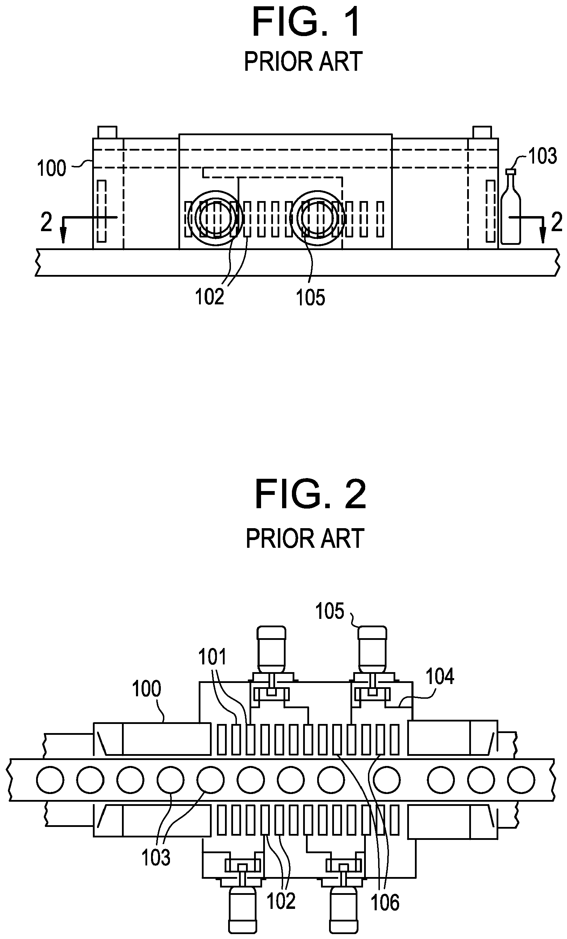

The present invention will be best understood by a brief initial discussion of a coating hood of the prior art. FIGS. 1 and 2 show a partially schematic view of a double-vapor-loop coating hood 100 for bottles according to U.S. Pat. No. 4,389,234. Each vapor loop has blowing slots 101, and on the opposite side of the conveyor, suction slots 102, which guide the circulating vapors at high velocity against the passing bottles 103. The liquid coating chemical is fed to each side of the hood through pipes 104 by blowers 105 from appropriate supply sources. Bottles coated in this type of hood using MBTC receive a uniform tin oxide coating at a relatively low chemical consumption. However, such hoods nevertheless require cleaning from time to time to remove crust from the interior, in order to maintain proper coating efficiency. The blowing slots 101 and suction slots 102 have flat sides 106. Under the conditions of high temperature encountered in forming glass articles, side 106 becomes hot due to the radiation of substantial amounts of heat from the bottles 103. In the coating application of the hood shown in FIG. 1, the circulating vapors can become quite hot, and, buildup of a metal oxide crust is found on the blowers, the inner walls of the hood and on the inside of suction slots 102.

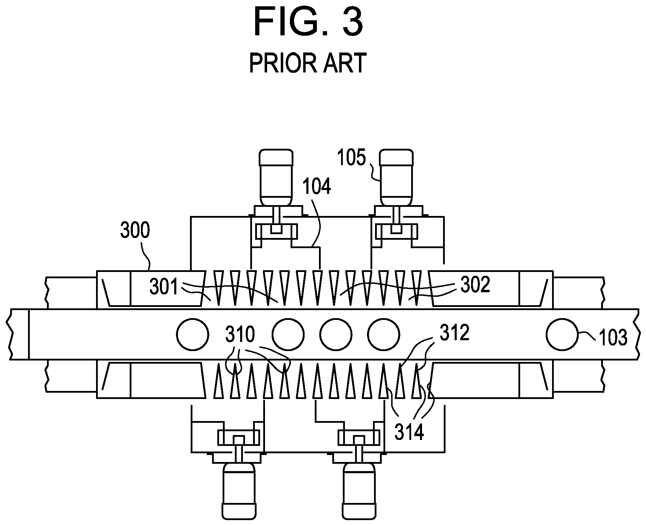

Turning now to prior art FIG. 3 of U.S. Patent No. 5,140,940 to Lindner, there is shown a conventional double-loop coating hood 300 which is similar to the high-efficiency conventional coating hood of the prior art, depicted in FIGS. 1 and 2. By changing the configuration of slots 101 and 102, Linder teaches that a substantial improvement in the economy of production of glass articles can be effected.

In prior art FIG. 3, the coating hood is shown generally at 300. Blowing slots 101 and suction slots 102 of FIGS. 1 and 2 are modified as shown for blowing slots 301 and suction slots 302 in hood 300, the modification being shown as the elimination of the flat side 106, such that the side walls 310 of the blowing slots 301 and suction slots 302 meet in vertical lines 312 in the interior of the hood. As a result of the conformation of the blowing slots 301 and suction slots 302, Linder teaches that thermal radiation from the hot bottles is spread over the inner surfaces 314 of the walls of the blowing and suction slots. Lindner teaches that because inner surfaces 314 are significantly larger than the inner-wall surface of the conventional coating hood of FIG. 1, the radiation energy per unit of wall surface is reduced by a factor which is a function of the ratio of the wall surfaces of the respective slots. Therefore, the inner surface temperature in the active part of the hood is from about 50 degrees Centigrade to about 150 degrees Centigrade lower than in a conventional hood of FIGS. 1 and 2. Linder teaches that this reduces crust buildup and therefore less need for cleaning.

The pipes 104 in prior art FIGS. 1-3 distribute the liquid coating chemical at a location that is directly above the fan blades of the blowers. Consequently, the fan blades of the blowers and the areas of the hood in close proximity to the fan blades get coated with the liquid coating chemical. This is viewed as inefficient because the hoods require frequent cleaning.

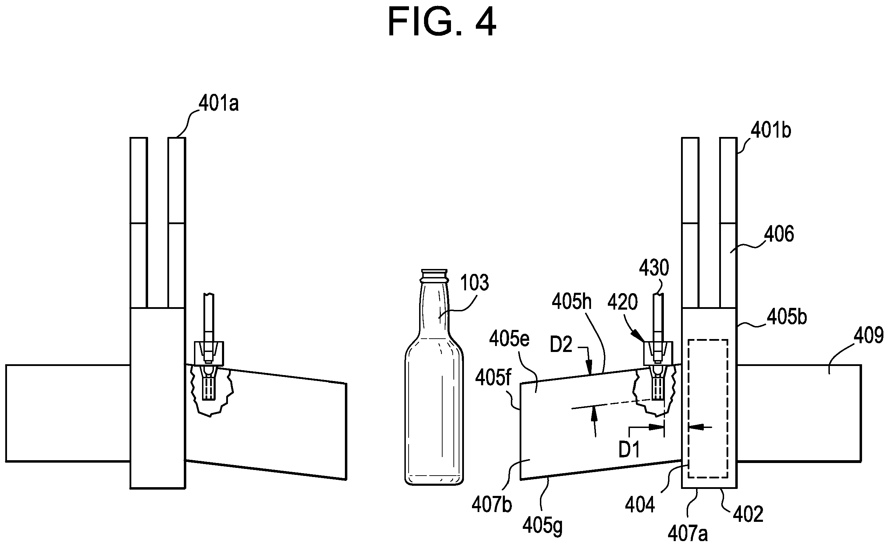

Turning now to FIGS. 4-6, a double vapor loop coating hood is shown generally at 400. The coating hood 400 is substantially similar to the hoods 100 and 300 of FIGS. 1-3, thus, the previous description of those hoods also applies to the coating hood 400.

The coating hood 400 generally includes two opposing hood sections 401a and 401b that are substantially identical. Although not shown, a central hood portion is positioned between the opposing hood sections 401a and 401b. Further details of the central hood portion can be found in U.S. Patent No. 4,668,268, which is incorporated by reference in its entirety for all purposes. The bottles 103 pass through an enclosed space that is defined between the opposing hood sections 401a and 401b. The enclosed space limits the escapement of the coating compound into the atmosphere.

The features the hood section 401b will be described hereinafter, however, it should be understood that the hood sections 401a and 401b are substantially identical. Thus, the foregoing description of the hood section 401b also applies to hood section 401a. The hood section 401b includes a plenum housing 402. The plenum housing 402 includes a rectangular shaped base portion 407a and a manifold portion 407b that extends from the front end of the base portion 407a.

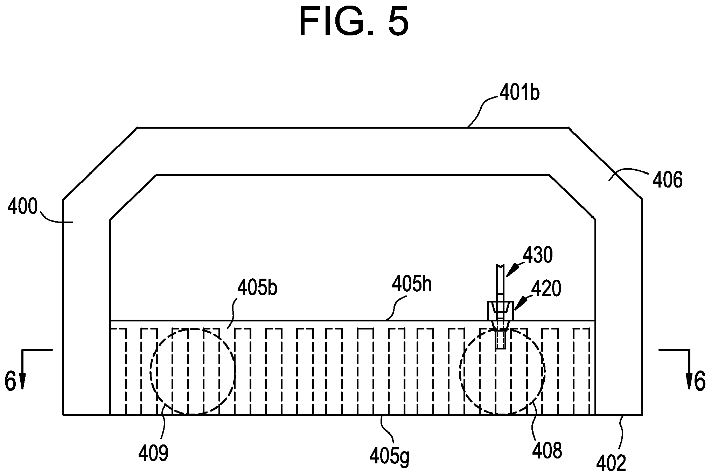

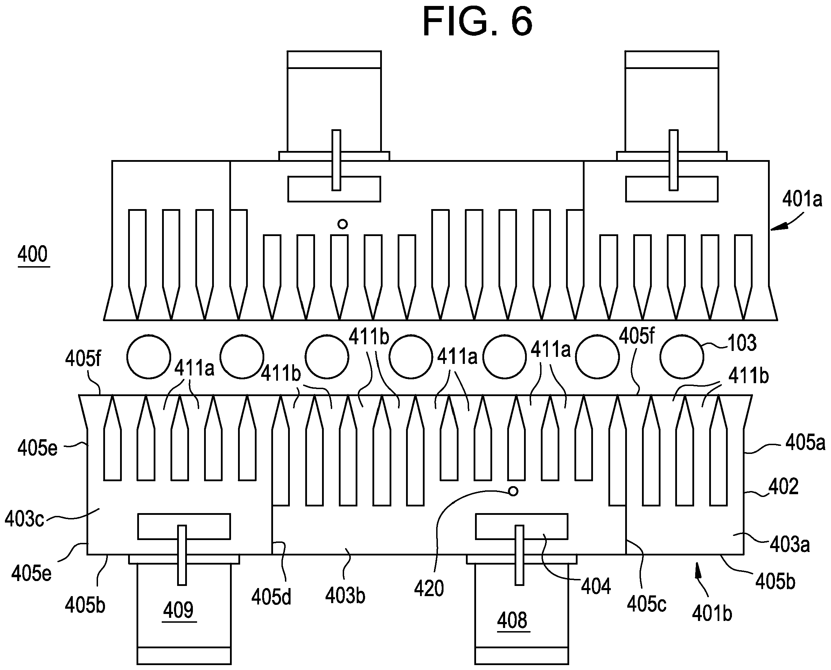

As best shown in FIGS. 5 and 6, three substantially enclosed interior chambers 403a-403c are defined in the plenum housing 402. The interior chamber 403a of the housing 402 is defined by the following walls of the housing 402: top wall 405h, bottom wall 405g, front wall 405f, outer wall 405a, rear wall 405b, and interior wall 405c. The interior chamber 403b of the housing 402 is defined by the following walls of the housing 402: top wall 405h, bottom wall 405g, front wall 405f, interior wall 405c, interior wall 405d, and rear wall 405b. Lastly, the interior chamber 403c of the housing 402 is defined by the following walls of the housing 402: top wall 405h, bottom wall 405g, front wall 405f, outer wall 405e, rear wall 405b, and interior wall 405d.

Referring to FIGS. 5 and 6, the interior chambers 403a and 403c are in fluid communication by virtue of a C-shaped hollow passage 406. Thus, fluid vapor travel from interior chamber 403a to chamber 403c via hollow passage 406.

Referring now to FIG. 6, a series of openings or slots 411a and 411b are defined on the front wall 405f of the plenum housing 402. Slots 411a are configured as blowing slots, whereas slots 411b are configured as suction slots. The blowing slots 411a may be referred to herein as an outlet or outlets, and the suction slots 411b may be referred to herein as an inlet or inlets. The purpose of the blowing and suction slots were described previously.

Two blowers 408 and 409 are mounted to the housing 402. Each blower 408 and 409 has a rotating fan blade 404 that is attached to a motor by a shaft. The fan blade 404 of the blower 408 is positioned in interior chamber 403b, and the fan blade 404 of the blower 408 is positioned in interior chamber 403c. The motors of the blowers 408 and 409 are optionally positioned outside of the housing 402.

In lieu of the previously-described pipes 104 that distribute the liquid coating directly onto the fan blades of a blower, the hood section 401b includes a injector 420 that is spaced from the pressure side of the blower fan blade 404 to reduce the potential for coating the fan blades and the surrounding areas of the housing 402 with the liquid coating chemical. Such positioning of the injector 420 simplifies cleaning of the hood section 401b and also maximizes the volume of the liquid coating chemical that is applied to the surfaces of the bottle 103.

As shown in FIG. 4, the injector 420 is mounted to the top wall 405h of the housing 402 adjacent to the fan blade 404 of the blower 408. The proximal end of the injector 420 is fluidly connected to a conduit 430 (a portion of which is shown) through which liquid coating chemical is distributed from a liquid coating supply (not shown). The side wall 405e of the housing 402 is partially cut-away to reveal the distal end of the injector 420.

As shown in FIG. 4, the distal end of the injector 420 of the hood section 401b is positioned downstream of the blower fan blade 404, and is spaced axially by a distance 'D1' from the blower fan blade 404. Distance D1 may be 0.5 to 5 inches, for example. It should be understood that distance D1 is not limited to any particular dimension.

The distal end of the injector 420 extends into the interior of the manifold portion 407b of the housing 402 by a distance 'D2.' Distance D2 may be 0.1 to 2 inches, for example. According to one exemplary aspect of the invention, distance D2 is 0.25 inches. It should be understood that distance D2 is not limited to any particular dimension.

Although not shown, another injector 420 may be mounted to the top wall 405h of the housing 402 in the vicinity of the other blower 409 of the hood section 401b.

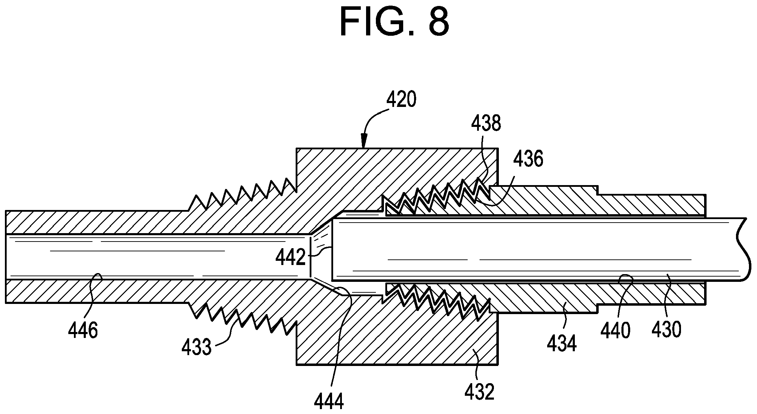

FIG. 8 depicts a cross-sectional view of the hollow conduit 430 mounted to the injector 420. The injector 420 includes a feed insert 432 and a nut 434 that is threadedly mounted to the feed insert 432. The nut 434 includes an exterior threaded section 436 that is threadedly engaged with interior threads 438 of the feed insert 432. The feed insert 432 includes a threaded region 433 on its exterior surface that is threadedly engaged with a threaded region (not shown) that is provided on the top wall 405h of the housing 402 (see FIG. 4).

The hollow conduit 430, feed insert 432 and nut 434 each have a substantially cylindrical hollow body. The hollow conduit 430 is positioned through a central bore 440 that is defined through the nut 434. The conduit 430 also extends into a central bore 446 that is defined through the feed insert 432. Upon threadedly mating the nut 434 onto the feed insert 432, the nut 434 may apply a radial pressure onto the hollow conduit 430, thereby retaining the hollow conduit 430 in a substantially fixed position within the hole 440 of the nut 434. The terminal end 442 of the hollow conduit 430 bears on a diagonal shoulder 444 that is defined on the central bore 446. The diagonal shoulder 444 and the central bore 446 of the feed insert 432 are sized to prevent the terminal end 442 of the hollow conduit 430 from passing into the interior of the housing 402 of the hood section 401b.

As noted above, the vertical distance D2, which the distal end of the feed insert 432 protrudes into the manifold portion 407b of the hood section 401b, is carefully selected to prevent the premature vaporization of the liquid coating chemical within the distal end of the conduit 430 or the bore 446 of the feed insert 432. The accumulation of vaporized coating chemical on the interior surfaces of the conduit 430 and/or the bore 446 of the feed insert 432 could result in a blockage within the injector 420.

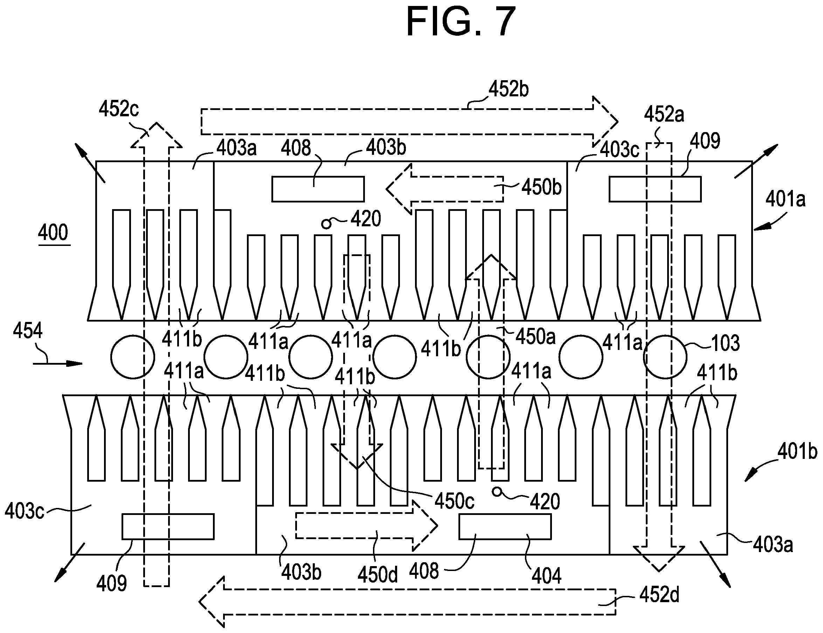

Referring back to FIG. 7, according to one exemplary method of operating the double vapor loop coating hood 400, the blowers 408 and 409 of each hood section 401a and 401b are first activated. The coating chemical is then delivered into the chamber 403b of each hood section 401a and 401b via the injectors 420. Thereafter the bottles 103 are conveyed along a path between the hood sections 401a and 401b, as indicated by arrow 454.

As noted above, the coating hood 400 has a double vapor loop. The primary loop 450 is depicted by air streams 450a-450d, whereas, the recycle loop 452 is depicted by air streams 452a-452d.

In the primary loop 450, the pressure side of the blowers 408 in the hood sections 401a and 401b propel air streams 450c and 450a past the injectors 420 of the hood sections 401a and 401b, respectively. Upon mixing with the coating chemical that is distributed by the injectors 420, the air streams 450c and 450a become entrained with vaporized coating chemical. The coating entrained air streams 450c and 450a are propelled out of the blowing slots 441a that are associated with the interior chambers 403b of the hood sections 401a and 401b, respectively, by the pressure side of the blowers 408. The coating entrained streams 450c and 450a pass over the bottles 103 that are positioned in front of those blowing slots 441a that are associated with the interior chambers 403c of the hood sections 401a and 401b, respectively, thereby coating the bottles 103 with the vaporized coating chemical.

The vacuum side of the blowers 408 of the hood sections 401a and 401b draws the air streams 450a and 450c through the suction slots 441b and into the interior chambers 403b of the hood sections 401a and 401b, respectively. The vacuum side of the blowers 408 of the hood sections 401a and 401b draws the coating entrained air streams 450b and 450d through the interior chambers 403 of the hood sections 401a and 401b, respectively. The primary loop then repeats as the pressure side of the blowers 408 propels the air streams 450c and 450a past the injectors 420 of the hood sections 401a and 401b, respectively.

As described above, the coating entrained air streams 450a and 450c contact the bottles 103. As the coating entrained air streams 450a and 450c contact the bottles 103, a portion of the coating entrained air streams 450a and 450c scatters outward toward the outer periphery of the hood sections. That scattered portion of the coating entrained air streams 450a and 450c is captured in the recycle loop 452.

In the recycle loop 452, the pressure side of the blowers 409 in the hood sections 401a and 401b propel air streams 452a and 452c out of the blowing slots 441a that are associated with the interior chambers 403c of the hood sections 401a and 401b, respectively. The air streams 452a and 452c mix with the scattered portion of the coating entrained air streams 450a and 450c of the primary loop 450. The coating entrained streams 452a and 452c of the recycle loop 452 pass over the bottles 103 that are positioned in front of those blowing slots 441a that are associated with the interior chambers 403c of the hood sections 401a and 401b, respectively, thereby twice coating the bottles 103 with the vaporized coating chemical.

As noted previously, the interior chambers 403a and 403c of each hood section are fluidly connected by passage 406. Thus, it follows that the vacuum side of the blowers 409 that are positioned in the interior chambers 403c of the hood sections 401b and 401a draw the coating entrained air streams 452a and 452c through the suction slots 441b that are associated with the interior chambers 403a of the hood sections 401b and 401a, respectively. The vacuum side of the blowers 409 then draw the air streams 452d and 452b through the passage 406 and into the interior chambers 403c of the hood sections 401b and 401a, respectively. The recycle loop then repeats as the pressure side of the blowers 409 in the hood sections 401a and 401b propel air streams 452a and 452c out of the blowing slots 441a that are associated with the interior chambers 403c of the hood sections 401a and 401b, respectively.

It should be understood that the above described method is not limited to any particular step or sequence of steps.

While preferred embodiments of the invention have been shown and described herein, it will be understood that such embodiments are provided by way of example only. Numerous variations, changes and substitutions will occur to those skilled in the art without departing from invention as defined by the appended claims.

## Claims

1. An apparatus for coating glass articles with a chemical compound comprising:
a coating hood section (401) defining an interior chamber (403);
a blower (408) having a fan blade (404); and
an injector (420) having a proximal end and a distal end,
said proximal end being fluidly connected to a conduit (430)
, said distal end being configured to deliver the chemical compound into the interior chamber (403) of the coating hood section (401), said distal end extending into the interior chamber by a first pre-determined distance D1 and positioned downstream from and spaced axially by a second predetermined distance D2 from said blower fan blade (404), **characterized in that** said distances are selected to prevent premature vaporization of the chemical compound within a distal end of the conduit, wherein the first pre-determined distance D1 is 0.5 to 5 inches and wherein the second pre-determined distance D2 is 0.1 to 2 inches.

2. The apparatus of claim 1, wherein the second pre-determined distance D2 is 0.25 inches.

3. The apparatus of claim 1, wherein the injector (420) includes a feed insert (432) and a nut (434) that is threadedly mounted to the feed insert (420).

4. The apparatus of claim 3, wherein the nut (434) includes an exterior threaded section (436) that is threadedly engaged with interior threads (438) of the feed insert (432).

5. The apparatus of claim 1 wherein the blower (408) is configured to deliver air into the interior chamber (403) that is to be mixed with the chemical compound.

6. The apparatus of claim 1 further comprising a conduit that is connected to the injector (420) through which the chemical compound is transported to the injector (420).

7. The apparatus of claim 6 further comprising a shoulder (444) formed in the injector (420), wherein an end of the conduit bears on the shoulder of the injector to prevent further movement of the conduit toward the shoulder.

8. The apparatus of claim 6, wherein the conduit (430) does not extend into the interior chamber (403).

9. The apparatus of claim 1 further comprising a threaded region defined on the injector (420) that is connected to a surface of the coating hood section.

10. The apparatus of claim 1, wherein the injector (420) comprises a central bore (446) through which the chemical compound is distributed into the interior chamber (403).

## Patentansprüche

1. Vorrichtung zum Beschichten von Glasartikeln mit einer chemischen Verbindung, umfassend:
einen Beschichtungshaubenabschnitt (401), der eine Innenkammer (403) definiert;
ein Gebläse (408) mit einem Ventilatorflügel (404); und
einen Injektor (420) mit einem nahen Ende und einem fernen Ende,
wobei das nahe Ende fließtechnisch mit einer Rohrleitung (430) verbunden ist,
wobei das ferne Ende ausgestaltet ist, um die chemische Verbindung in die Innenkammer (403) des Beschichtungshaubenabschnitts (401) hinein abzugeben, wobei sich das ferne Ende mit einer ersten vorbestimmten Distanz D1 in die Innenkammer hinein erstreckt und nachgeordnet zu und mit einer zweiten vorbestimmten Distanz D2 axial beanstandet von dem Ventilatorflügel (404) des Gebläses positioniert ist, **dadurch gekennzeichnet, dass** die Distanzen ausgewählt werden, um vorzeitige Verdampfung der chemischen Verbindung innerhalb eines fernen Endes der Rohrleitung zu verhindern, wobei die erste vorbestimmte Distanz D1 0,5 bis 5 Zoll beträgt, und wobei die zweite vorbestimmte Distanz D2 0,1 bis 2 Zoll beträgt.

2. Vorrichtung nach Anspruch 1, wobei die zweite vorbestimmte Distanz D2 0,25 Zoll beträgt.

3. Vorrichtung nach Anspruch 1, wobei der Injektor (420) einen Einsatzmaterialeinsatz (432) und eine Mutter (434) aufweist, die geschraubt an dem Einsatzmaterialeinsatz (420) montiert ist.

4. Vorrichtung nach Anspruch 3, wobei die Mutter (434) einen Außengewindeabschnitt (436) einschließt, der geschraubt in Eingriff mit dem Innengewinde (438) des Einsatzmaterialeinsatzes (432) ist.

5. Vorrichtung nach Anspruch 1, wobei das Gebläse (408) ausgestaltet ist, um Luft in die Innenkammer (403) abzugeben, die mit der chemischen Verbindung gemischt werden soll.

6. Vorrichtung nach Anspruch 1, ferner umfassend eine Rohrleitung, die mit dem Injektor (420) verbunden ist, durch den die chemische Verbindung zu dem Injektor (420) transportiert wird.

7. Vorrichtung nach Anspruch 6, ferner umfassend eine Schulter (444), die in dem Injektor (420) gebildet ist, wobei ein Ende der Rohrleitung auf der Schulter des Injektors ruht, um weitere Bewegung der Rohrleitung in Richtung der Schulter zu verhindern.

8. Vorrichtung nach Anspruch 6, wobei die Rohrleitung (430) sich nicht in die Innenkammer (403) hinein erstreckt.

9. Vorrichtung nach Anspruch 1, ferner umfassend eine Gewinderegion, die auf dem Injektor (420) definiert ist, der mit einer Oberfläche des Beschichtungshaubenabschnitts verbunden ist.

10. Vorrichtung nach Anspruch 1, wobei der Injektor (420) eine zentrale Bohrung (446) umfasst, durch welche die chemische Verbindung in die Innenkammer (403) hinein verteilt wird.

## Revendications

1. Appareil pour revêtir des articles de verre avec un composé chimique, comprenant:
une section de hotte de revêtement (401) qui définit une chambre intérieure (403);
une soufflante (408) présentant une pale de ventilateur (404); et
un injecteur (420) présentant une extrémité proximale et une extrémité distale,
ladite extrémité proximale étant connectée fluidiquement à un conduit (430),
ladite extrémité distale étant configurée de manière à délivrer le composé chimique dans la chambre intérieure (403) de la section de hotte de revêtement (401), ladite extrémité distale s'étendant à l'intérieur de la chambre intérieure d'une première distance prédéterminée D1 et étant positionnée en aval et espacée axialement d'une seconde distance prédéterminée D2 de ladite pale de ventilateur (404) de la soufflante,
**caractérisé en ce que** lesdites distances sont sélectionnées de manière à empêcher une évaporation prématurée du composé chimique à l'intérieur d'une extrémité distale du conduit,
dans lequel la première distance prédéterminée D1 est comprise entre 0,5 pouce et 5 pouces, et
dans lequel la seconde distance prédéterminée D2 est comprise entre 0,1 pouce et 2 pouces.

2. Appareil selon la revendication 1, dans lequel la seconde distance prédéterminée D2 est de 0,25 pouce.

3. Appareil selon la revendication 1, dans lequel l'injecteur (420) comprend un insert d'alimentation (432) et un écrou (434) qui est monté de façon vissée sur l'insert d'alimentation (420).

4. Appareil selon la revendication 3, dans lequel l'écrou (434) comprend une section filetée extérieure (436) qui est engagée de façon vissée avec des filets intérieurs (438) de l'insert d'alimentation (432).

5. Appareil selon la revendication 1, dans lequel la soufflante (408) est configurée de manière à délivrer à l'intérieur de la chambre intérieure (403) de l'air qui doit être mélangé avec le composé chimique.

6. Appareil selon la revendication 1, comprenant en outre un conduit qui est connecté à l'injecteur (420) et à travers lequel le composé chimique est transporté jusqu'à l'injecteur (420).

7. Appareil selon la revendication 6, comprenant en outre un épaulement (444) formé dans l'injecteur (420), dans lequel une extrémité du conduit s'appuie sur l'épaulement de l'injecteur afin d'empêcher tout déplacement supplémentaire du conduit en direction de l'épaulement.

8. Appareil selon la revendication 6, dans lequel le conduit (430) ne s'étend pas à l'intérieur de la chambre intérieure (403).

9. Appareil selon la revendication 1, comprenant en outre une région filetée définie sur l'injecteur (420) qui est connectée à une surface de la section de hotte de revêtement.

10. Appareil selon la revendication 1, dans lequel l'injecteur (420) comprend un alésage central (446) à travers lequel le composé chimique est distribué dans la chambre intérieure (403).
